# EUROPÄISCHE PATENTSCHRIFT

(11) **EP 0 408 021 B1**
(45) Veröffentlichungstag und Bekanntmachung des Hinweises auf die Patenterteilung: **06.10.1993**
(21) Anmeldenummer: 90113307.4
(22) Anmeldetag: 12.07.1990
(51) Int. Cl.: B65G 53/02, B65G 51/00

(54) **Vorrichtung zum Transportieren und Positionieren von scheibenförmigen Werkstücken, insbesondere Halbleiterscheiben, und Verfahren zur nasschemischen Oberflächenbehandlung derselben**
Device for transporting and positioning of disk-shaped work pieces, especially semiconductor wafers, and method for their wet chemical surface treatment
Dispositif pour transporter et positioner des pièces à usiner en forme de disque, notamment des disques semi-conducteurs et procédé pour le traitement chimique en surface, par voie humide de celles-ci

(30) Priorität: 14.07.1989 DE 3923405
(43) Veröffentlichungstag der Anmeldung: 16.01.1991
(73) Patentinhaber: Wacker-Chemitronic Gesellschaft für Elektronik-Grundstoffe mbH, D-84489 Burghausen (DE)
(72) Erfinder: Müller, Alois, D-8342 Tann (DE); Wimmer, Erich, D-8261 Stammham (DE); Seidl, Helmut, D-8263 Burghausen (DE); Eigner, Laszlo, D-8347 Kirchdorf, Machendorf (DE)

(56) Entgegenhaltungen:
- US-A- 3 797 889
- US-A- 4 618 292

## Beschreibung

Vorrichtung zum Transportieren und Positionieren von scheibenförmigen Werkstücken, insbesondere Halbleiterscheiben, und Verfahren zur naßchemischen Oberflächenbehandlung derselben.

Die Erfindung betrifft eine Vorrichtung zum Transportieren und Positionieren von scheibenförmigen Werkstücken, insbesondere Halbleiterscheiben, bei welcher die Werkstücke mit Hilfe fluider Medien über eine mit seitlichen Einfassungen versehene Führungsplatte bewegt werden, wobei die Medien durch im Plattenboden angeordnete, in Transportrichtung geneigte Düsen in den Transportraum eingepreßt werden, in welchem mindestens ein Bereich zum Abbremsen und Positionieren der Werkstücke vorgesehen ist, wobei im Abbremsbereich mit fluidem Medium beaufschlagte Bremsdüsen vorgesehen sind. Sie betrifft ferner ein Verfahren zur naßchemischen Oberflächenbehandlung von scheibenförmigen Werkstücken, insbesondere Halbleiterscheiben, bei dem eine oder mehrere Flüssigkeiten zur Einwirkung auf die Scheibenoberfläche gebracht werden und die Scheiben mindestens einem Transportvorgang unterworfen werden.

Eine Vorrichtung der eingangs genannten Art ist aus der DE-B-20 36 337, angemeldet 22. 7. 70 mit Priorität der US-Anmeldung mit Aktenzeichen 844 918 vom 25. 7. 69, Anmelder Texas Instruments Inc., bekannt. Als Transportmittel werden dabei unter Druck stehende gasförmige oder auch flüssige Medien, üblicherweise Luft, eingesetzt. Zum Abbremsen werden die Werkstücke an einer vorgesehenen Stelle zur Anlage an einer Bremsfläche gebracht, so daß durch mechanische Reibung zunächst die Geschwindigkeit verringert wird, bis die Scheiben nahe einer vorgegebenen Stelle zur Ruhe kommen und schließlich in ihre endgültige Position gebracht werden können. Ein solcher Kontakt mit Bremsflächen kann jedoch bereits zu einer unzulässigen Kontamination der Werkstücke führen, was insbesondere für Halbleiterscheiben gilt, an die von den Bauelementeherstellern äußerst hohe Reinheitsanforderungen gestellt werden. Überdies gestattet diese Vorrichtung nur translatorische, nicht aber rotatorische Bewegungen der Scheiben.

Aus der EP-B-130 866 bzw. der entsprechenden US-PS 4,557,785 ist eine weitere derartige Vorrichtung bekannt, bei der die Scheiben nach einer unter Rotation in einer Ätzstation durchgeführten Ätz- und Spülbehandlung mittels Düsen durch ein Spülbad transportiert und schließlich in einen Schleudertrockner überführt werden, in dem anhaftendes Wasser abgeschleudert wird, so daß die schließlich erhaltenen trockenen Scheiben dann für den nächsten Behandlungsschritt entnommen werden können. Sowohl das Einbringen der Scheiben in die Ätzstation als auch das Abbremsen der Scheiben beim Einbringen in den Schleudertrockner und das Trockenschleudern geschieht dabei mit mechanischen Hilfsmitteln, so daß eine Kontamination oder Beschädigung der Scheiben nicht auszuschließen ist. Überdies muß die Ätzstation durch mechanische Bewegung ihrer Abdeckung jeweils zum Ein- bzw. Ausbringen der Scheibe geöffnet werden, was natürlich auch die Gefahr einer Kontamination durch Abrieb beinhaltet. Ein weiterer Nachteil liegt darin, daß die Ätzstation abwechselnd mit Ätzmittel und Wasser beschickt wird, so daß eine Verschleppung von Chemikalienresten möglich ist.

Aus der Patentschrift US-4,618,292 ist eine Vorrichtung bekannt, mit der Halbleiterscheiben auf einem Luftkissen transportiert werden. Gemäß der Offenbarung dieser Patentschrift werden die Halbleiterscheiben zum Abbremsen an die Transportunterlage gesaugt.

Die Aufgabe der Erfindung lag darin, eine Vorrichtung der eingangs genannten Art anzugeben, die diese Nachteile vermeidet und es ermöglicht, insbesondere Halbleiterscheiben ohne mechanischen Kontakt zu transportieren, anzuhalten, zu positionieren, gegebenenfalls in Rotation zu versetzen und weiterzutransportieren sowie gegebenenfalls dabei die Scheiben einem oder mehreren naßchemischen Behandlungs- und/oder Reinigungsschritten zu unterziehen. Die Aufgabe lag ferner darin, ein entsprechend gestaltetes, derartige Schritte beinhaltendes Verfahren anzugeben.

Gelöst wird die Aufgabe durch eine Vorrichtung, welche dadurch gekennzeichnet ist, daß im Abbremsbereich im Plattenboden Bremsdüsen vorgesehen sind, welche unter einem gegen die Transportrichtung geneigten Winkel in der Führungsplatte angeordnet sind und zumindest beim Abbremsen und Positionieren eines Werkstückes mit fluiden Medium beaufschlagt werden. Vorteilhafte Ausgestaltungen der Vorrichtung ergeben sich aus den abhängigen Ansprüchen. Das die Aufgabe lösende Verfahren der eingangs genannten Art ist dadurch gekennzeichnet, daß die Scheiben mindestens eine derartige Vorrichtung durchlaufen, wobei die zur Einwirkung zu bringende Flüssigkeit auch für den Transportvorgang in der Vorrichtung eingesetzt wird.

Die Führungsplatte wird zweckmäßig aus gegenüber den jeweils eingesetzten fluiden Medien weitgehend inertem Material gefertigt, das auch gegenüber den zu transportierenden Scheiben nicht kontaminierend wirken kann. Beim Transport von besonders empfindlichen scheibenförmigen Werkstücken wie Halbleiterscheiben aus Silicium, Germanium, Galliumarsenid oder Indiumphosphid, aber auch von Scheiben aus oxidischem Material wie Gallium-Gadolinium-Granat, Saphir, Spinell oder Glaswerkstoffen, haben sich vor allem Kunststoffe bewährt, wobei insbesondere Polymethylmethacrylate ("Plexiglas"), aber auch Polytetrafluorethylen, Polycarbonate, Polyvinylidenfluoride, Perfluoroalkoxyalkane, Acrylglas oder ähnliche Werkstoffe, aber auch Glas eingesetzt werden können. Vorteilhaft ist die Anwendung von transparenten oder durchsichtigen Materialien, da sie in einfacher Weise die visuelle und/oder mittels optischer Sensoren vorgenommene Überwachung und gegebenenfalls auch Steuerung der Bewegung der Werkstücke oder der Zufuhr bzw. des Abflusses der eingesetzten fluiden Medien gestatten. Wichtig ist auch, daß das ausgewählte Material genügend formstabil ist, um eine präzise und maßhaltige Orientierung der Düsen wie auch eine genaue Oberflächenbearbeitung zu ermöglichen, so daß eine einen einwandfreien und ungestörten Fluß des Fluids gestattende, plane und von Unebenheiten freie Oberfläche des Bodens der Führungsplatte, beispielsweise durch Polieren, bereitgestellt und unter den Betriebsbedingungen aufrechterhalten werden kann.

Vorteilhaft bestehen die das seitliche Austreten des Fluids verhindernden seitlichen Einfassungen der Führungsplatte aus dem selben Material wie die Führungsplatte selbst, was jedoch nicht zwingend vorgeschrieben ist. In den Fällen, in denen höchste Reinheitsanforderungen gestellt werden, können sie auch aus dem Material gefertigt sein, aus dem die zu transportierenden Scheiben bestehen. Auf diese Weise läßt sich die Gefahr einer Verunreinigung durch Abrieb gering halten, da es im allgemeinen nicht vollständig ausgeschlossen werden kann, daß auch bei sehr genau gearbeiteten Führungsplatten die Scheiben seitlich von der idealen Transportrichtung abweichen und in Kontakt mit den Einfassungen kommen, beispielsweise beim Auftreten von Druckschwankungen im Fluidsystem. Die Einfassungen können mit dem Plattenboden lösbar, z.B. durch Schraub- oder Steckverbindungen, oder fest, beispielsweise durch Verkleben oder Verschweißen, verbunden sein. Im allgemeinen hat es sich bewährt, die Führungsplatte so zu dimensionieren, daß zwischen dem Außenumfang der zu transportierenden Scheibe und den beiderseitigen Einfassungen jeweils ein freier Zwischenraum von 2 bis 50 mm verbleibt. Diese Werte müssen jedoch nicht zwingend eingehalten werden, beispielsweise im Falle von Anordnungen, die für den Transport von Scheiben mit verschiedenen Durchmessern vorgesehen sind.

Letztlich besitzt die Führungsplatte die Form eines flachen Troges mit vorzugsweise rechteckigem oder trapezoidem Querschnitt, wobei gegebenenfalls die seitlichen Ecken gerundet sein können. Zweckmäßig wird, schon um das Einschleppen von Partikeln oder Verunreinigungen zu verhindern, zusätzlich eine obere Abdeckung vorgesehen, die zumindest teilweise, günstig aber vollständig die Führungsplatte bedeckt und von oben her abschließt. Vorteilhaft ist die nach innen weisende Oberfläche der Abdeckung, wie die nach innen weisende Bodenfläche der Führungsplatte, möglichst plan und glatt, um ein ungestörtes Durchtreten des Fluides wie auch der transportierten Scheiben zu ermöglichen. Die Höhe des umschlossenen Raumes bzw. der Abstand der Abdeckung von der Bodenfläche der Führungsplatte richtet sich nach den angestrebten Durchflußraten und der Dicke der zu transportierenden Scheiben; als Richtwert für die mindestens erforderliche Höhe, der allerdings nicht im Sinne einer Beschränkung zu verstehen ist, hat sich beispielsweise beim Transport von Halbleiterscheiben mittels wässriger Medien ein etwa der dreifachen Scheibendicke entsprechender Wert erwiesen, während die bevorzugten Werte im Bereich von 2.5 bis 15 mm liegen. Die Höhe braucht dabei nicht über die gesamte Länge der Führungsplatte hinweg konstant gehalten zu werden, sondern kann gegebenenfalls auch verringert oder vergrößert werden. Eine Abdeckung des Systems hat auch den Vorteil, daß sie ebenfalls mit Düsen versehen werden kann, was sich in allen Bereichen der Führungsplatte gleichermaßen als günstig erwiesen hat.

Als Fluide können grundsätzlich Gase oder Flüssigkeiten eingesetzt werden, die chemisch die gewünschten reaktiven oder inerten Eigenschaften besitzen und eine geeignete, niedrige Viskosität zur Einstellung der erforderlichen Strömungsverhältnisse aufweisen. Schon aus Kostengründen wird als Gas bevorzugt Druckluft, gegebenenfalls in partikelarmer Form, eingesetzt, sofern nicht aus Reinheitsgründen Rein- oder Reinstgase wie Stickstoff, Argon oder Helium erforderlich sind. Bei den gegenüber Gasen im allgemeinen bevorzugt verwendeten Flüssigkeiten gelangen wässrige Medien, d.h. Wasser und/oder wässrige Lösungen, die beispielsweise chemische Reagenzien oder Spül- bzw. Reinigungsmittel enthalten können, mit besonderem Vorteil zur Anwendung.

Besondere Bedeutung kommt der Anordnung der das jeweils eingesetzte Fluid in den Innenraum der Führungsplatte freigebenden Düsen im Plattenboden zu. Im folgenden werden die eine Bewegung des zu transportierenden scheibenförmigen Werkstückes in der vorgesehenen Richtung bewirkenden Düsen als Vorschubdüsen, die eine Verlangsamung dieser Bewegung bewirkenden Düsen als Bremsdüsen und die eine Rotation des Werkstückes bewirkenden Düsen als Rotationsdüsen bezeichnet. Als Bezugsebene dient die geometrisch ideale innere Bodenfläche der Führungsplatte, wobei etwaige in der realen Oberfläche vorhandene minimale Unebenheiten außer Betracht bleiben sollen. Unter Transportrichtung ist diejenige Richtung zu verstehen, in der sich bei idealem, ungestörtem Transportverlauf der Schwerpunkt des scheibenförmigen Werkstückes über die Führungsplatte bewegt. In der Regel verläuft die Transportrichtung im wesentlichen parallel zur Längsachse der Führungsplatte.

Zweckmäßig werden die im Plattenboden sowie gegebenenfalls auch in der Abdeckung vorgesehenen Düsen zu Gruppen zusammengefaßt, die jeweils über einen gemeinsamen Versorgungskanal mit dem Fluid, insbesondere dem wässrigen Medium versorgt werden. Die Anordnung der Düsen folgt dann den jeweiligen Versorgungskanälen, die soweit als möglich gerade verlaufen, da sie so am leichtesten in der ggf. aus zwei Hälften zusammengesetzten Führungsplatte, z.B. durch Bohren oder Fräsen, angelegt werden können. Günstig ist es auch, die Vorschub-, Brems- und Rotationsdüsen über voneinander unabhängige Kanäle zu versorgen, so daß sie nicht gleichzeitig und andauernd beschickt werden, sondern nur bei Bedarf mit Fluid beaufschlagt werden können.

Die Form und lichte Weite der Düsen richtet sich im wesentlichen nach dem jeweils eingesetzten fluiden Medium und wird zweckmäßig in Vorversuchen auf die erwünschten Transportbedingungen hin optimiert. Bei den bevorzugten wässrigen Medien haben sich beispielsweise Düsen mit rundem Querschnitt und Durchmessern im Bereich von 0.1 bis 5 mm, vorteilhaft 0.5 bis 1.5 mm bewährt, wobei die Untergrenze im Regelfall durch die Viskosität der Medien und die Größe der enthaltenen Partikel, die Obergrenze letztlich durch die verfügbare Pumpleistung und die noch vertretbaren Durchflußmengen vorgegeben ist. Anstelle von Düsen mit rundem Querschnitt können auch solche mit ovalem, quadratischem, rechteckigem oder schlitzartigem Querschnitt vorgesehen werden. Allgemein ist es auch möglich, durch die Gestaltung der Auslaßöffnung die Austrittscharakteristik des Mediums zu beeinflussen, und beispielsweise Voll-, Streu- oder Sprühstrahlen oder entsprechende Mischformen vorzusehen.

Wichtig ist es auch, die verschiedenen Fluidversorgungssysteme möglichst weitgehend gegenüber Druckschwankungen zu sichern. Dies kann beispielsweise mit Hilfe von Druckreglern oder Puffern geschehen. Allgemein konnten bei wässrigen wie bei gasförmigen Medien mit Betriebsdrücken von etwa 200 bis 500 kPa gute Ergebnisse erzielt werden. Der erforderliche Druck kann beispielsweise mittels handelsüblicher Pumpen oder Hochbehältern erzeugt werden.

Im Plattenboden der Führungsplatte sind die einzelnen Vorschubdüsen so angeordnet, daß sie jeweils in einer zum Plattenboden im wesentlichen senkrechten, im wesentlichen parallel zur Transportrichtung verlaufenden Ebene liegen, wobei auch Abweichungen von dieser idealen Orientierung vorgesehen sein können, sofern die resultierenden Momente so zusammenwirken, daß sie im wesentlichen in Transportrichtung gerichtet sind. Grundsätzlich sind jedoch auch Anordnungen nicht ausgeschlossen, bei denen diese Ebene, in Transportrichtung gesehen, mit dieser einen spitzen Winkel einschließt, so daß der von den Düsen ausgehende Fluidstrahl jeweils von außen schräg zur Längsachse der Führungsplatte und der Transportrichtung im wesentlichen gleich gerichtet ist. Dabei ist auch die Anwendung von Mischformen nicht ausgeschlossen, die sowohl derart schräg wie auch parallel zur Transportrichtung ausgerichtete Vorschubdüsen besitzen.

In Transportrichtung betrachtet, bilden die Düsen mit dem Plattenboden einem spitzen Winkel, und zwar vorteilhaft zwischen 30 und 60°, bevorzugt etwa 45°. Bevorzugt wird für diese Düsen eine Anordnung vorgesehen, bei der sie mehrere parallel zur Transportrichtung bzw. der Längsachse der Führungsplatte verlaufende, verschiedenen oder günstig gleichen Abstand zueinander aufweisende Reihen bilden, innerhalb derer sie in wechselndem oder günstig gleichem Abstand aufeinanderfolgend angeordnet sind. Einander entsprechende Düsen in den verschiedenen Reihen werden vorteilhaft so in die Bodenplatte eingebracht, daß sie eine im wesentlichen geradlinige Front ausbilden, obwohl grundsätzlich auch ein gekrümmter Frontverlauf nicht ausgeschlossen ist.

Die erfindungsgemäß im Plattenboden vorgesehenen Bremsdüsen sind vorzugsweise ebenfalls so angeordnet, daß sie in einer zum Plattenboden im wesentlichen senkrechten Ebene liegen, die im wesentlichen parallel zur Transportrichtung verläuft, wobei auch Abweichungen von dieser idealen Orientierung vorgesehen sein können, sofern die resultierenden Momente so zusammenwirken, daß sie im wesentlichen in Transportrichtung gerichtet sind. Grundsätzlich sind jedoch auch Anordnungen nicht ausgeschlossen, bei denen diese Ebene, in Transportrichtung gesehen, mit dieser einen stumpfen Winkel einschließt, so daß der von den Düsen ausgehende Fluidstrahl jeweils von außen schräg zur Längsachse der Führungsplatte und der Transportrichtung im wesentlichen entgegen gerichtet ist. Dabei ist auch die Anwendung von Mischformen nicht ausgeschlossen, die sowohl derart schräg wie auch parallel zur Transportrichtung ausgerichtete Bremsdüsen besitzen.

Die Bremsdüsen sind gegenüber dem Plattenboden geneigt ausgerichtet, und zwar beträgt der Neigungswinkel in Transportrichtung gesehen 90 bis 170°, vorzugsweise 120 bis 150° und günstig etwa 135°, so daß die Bremsdüsen letztendlich also gegen die Transportrichtung geneigt sind. Bevorzugt wird wie bei den Vorschubdüsen auch für die Bremsdüsen eine Anordnung vorgesehen, bei der sie mehrere parallel zur Transportrichtung bzw. der Längsachse der Führungsplatte verlaufende, verschiedenen oder günstig gleichen Abstand zueinander aufweisende Reihen bilden, innerhalb derer sie in wechselndem oder günstig gleichem Abstand aufeinanderfolgend angeordnet sind. Einander entsprechende Düsen in den verschiedenen Reihen werden vorteilhaft so in die Bodenplatte eingebracht, daß sie eine im wesentlichen geradlinige Front ausbilden, obwohl grundsätzlich auch ein gekrümmter Frontverlauf nicht ausgeschlossen ist. Dabei ist es nicht zwingend vorgeschrieben, daß alle Bremsdüsen den selben Neigungswinkel besitzen; es sind auch Anordnungen denkbar, bei denen die Düsen innerhalb einer Reihe unter verschiedenen Neigungswinkeln ausgerichtet sind und beispielsweise von einer nahezu oder genau senkrechten in eine stärker geneigte Position übergehen, wobei dieser Übergang auch in Stufen erfolgen kann. Günstig sind die Reihen der Brems- und der Vorschubdüsen jeweils in einer Linie angeordnet.

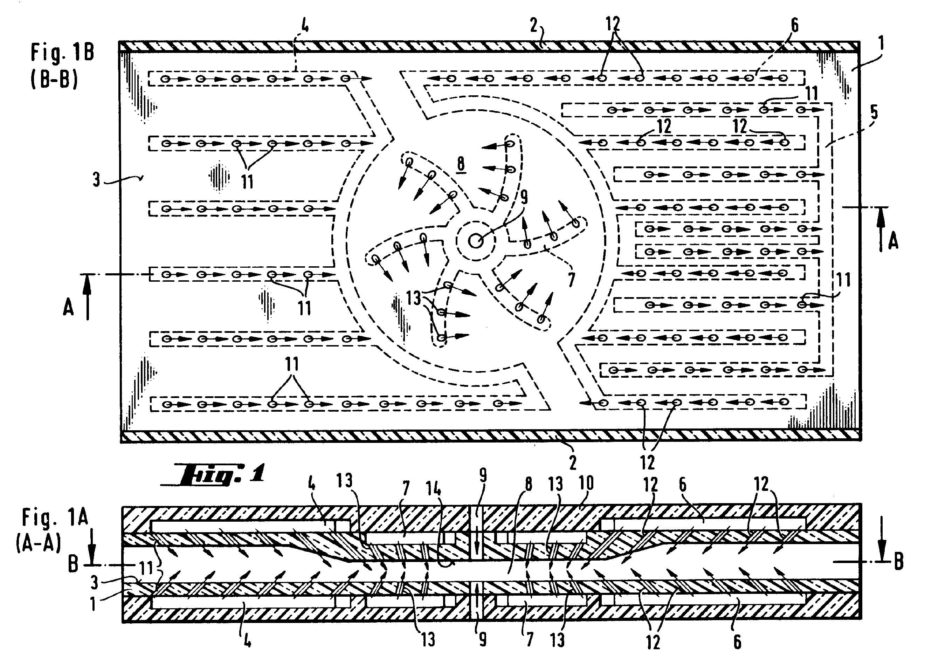

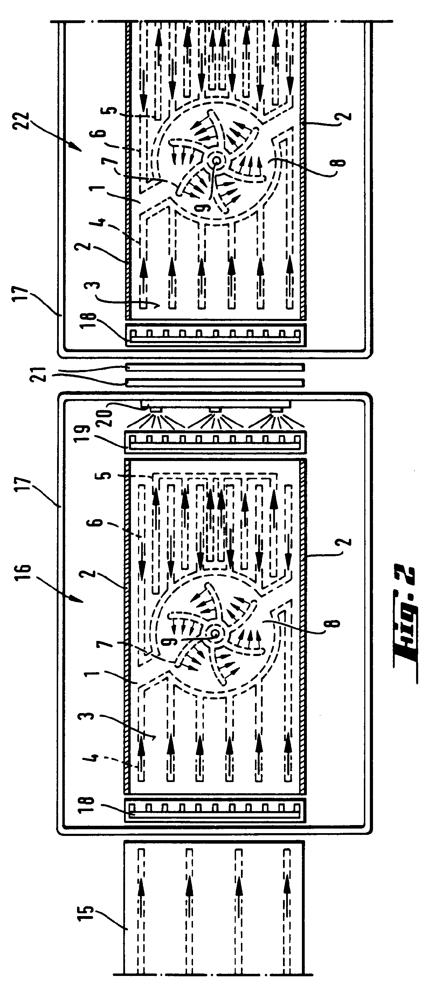

Beispiele für mögliche Anordnungen der Vorschub- und Bremsdüsen sowie gegebenenfalls der zusätzlich vorhandenen Rotationsdüsen werden nachstehend an Hand der Figuren 1 und 2 erläutert, ebenso wie mögliche Ausführungsformen von Verfahren zur naßchemischen Oberflächenbehandlung von Scheiben, insbesondere Halbleiterscheiben unter Einsatz der vorgestellten Vorrichtungen. Figur 1 zeigt dabei schematisch eine mögliche Ausgestaltung einer Führungsplatte mit Vorschub-, Brems- und Rotationsdüsen in einer Draufsicht und einem idealisierten Längsschnitt, Figur 2 einen Ausschnitt aus einer Behandlungsstraße mit hintereinandergeschalteten Vorrichtungen, die nacheinander von den zu behandelnden Scheiben durchlaufen werden. Einander entsprechende Elemente sind in beiden Figuren mit den gleichen Bezugszeichen versehen.

In Figur 1 ist eine Führungsplatte 1, beispielsweise aus Polymethylmethacrylat (Plexiglas), mit seitlichen Einfassungen 2 dargestellt. In den planen Plattenboden 3 sind voneinander unabhängige Versorgungskanalsysteme 4, 5, 6 und 7 eingebracht, wobei über die Kanalsysteme 4 und 5 die Vorschubdüsen 11, über das System 6 die Bremsdüsen 12 und über das System 7 die bei der dargestellten Vorrichtung vorhandenen und vorteilhaften, aber nicht zwingend vorgeschriebenen Rotationsdüsen 13 mit beispielsweise wässrigem Medium versorgt werden können. Aus Gründen der Übersichtlichkeit sind die einzelnen, von den Kanälen ausgehenden Reihen der Düsen nur schematisch dargestellt; die Pfeile in bzw. an den Kanälen geben jedoch die Hauptrichtung an, in welche sich das aus den Düsen ausströmende Medium bewegt. Die Transportrichtung, welche nicht eigens angedeutet ist, verläuft parallel zur Längsachse der Führungsplatte von links nach rechts.

Gemäß einer bevorzugten Ausführungsform der Erfindung ist in dem Bereich der Führungsplatte, in dem die transportierte Scheibe durch die Einwirkung der Bremsdüsen zum Stehen kommt, ein zusätzlicher Rotationsbereich 8 vorgesehen, in dem diese bei oder nach dem Abbremsen in Rotation versetzt werden kann. Die in diesem Bereich vorgesehenen, hier aus Gründen der Übersichtlichkeit schematisch dargestellten Rotationsdüsen 13 folgen in ihrer Anordnung vorteilhaft Linien, die von einem gemeinsamen Mittelpunkt, der im wesentlichen auch dem Mittelpunkt der Scheibenrotation entspricht, radial ausgehen. Diese Linien können gerade verlaufen, sind bevorzugt aber gekrümmt, und folgen vorteilhaft Kreislinien, aber auch elliptischen, parabel- oder hyperbelförmigen Kurvenausschnitten, wobei die Krümmungsmittelpunkte jeweils in der vorgesehenen Drehrichtung liegen. Zweckmäßig folgt in der in der Fig. 1 dargestellten Weise dieser jeweils für die Anordnung der Rotationsdüsen gewählten Linienführung auch das Versorgungskanalsystem 7, über welches das schließlich freigegebene Fluid bereitgestellt wird, obwohl grundsätzlich auch anders gestaltete Systeme, beispielsweise in der Art von Ringkanälen, nicht ausgeschlossen sind.

Für eine zuverlässige Scheibenrotation sind mindestens 3, vorteilhaft 4 bis 10 derartiger von einem gemeinsamen Mittelpunkt ausgehender und der jeweils gewählten, vorzugsweise gekrümmten Linienführung folgender Reihen von Rotationsdüsen erforderlich. Bevorzugt besitzt diese Anordnung bezüglich des gemeinsamen Mittelpunktes Rotationssymmetrie. Als günstig hat es sich auch erwiesen, wenn bei diesen Reihen einander entsprechende Düsen jeweils auf bezüglich des gemeinsamen Mittelpunktes konzentrischen Kreisen liegen. Dabei hat es sich besonders bewährt, wenn die Radiendifferenz aufeinanderfolgender Kreise nicht konstant bleibt, sondern von innen nach außen abnimmt, so daß sich letztlich von innen nach außen innerhalb einer Düsenreihe die Entfernung benachbarter Düsen voneinander verringert.

Günstig entspricht die mit Rotationsdüsen bestückte Fläche des Rotationsbereiches 8 annähernd der Oberfläche des transportierten scheibenförmigen Werkstückes. Als vorteilhaft, insbesondere im Hinblick auf die Lagestabilität der rotierenden Scheibe, hat es sich erwiesen, wenn die äußersten Rotationsdüsen so angeordnet sind, daß sie sich noch innerhalb der von dieser bei der Drehbewegung überstrichenen Fläche befinden. Günstig beträgt der Abstand der jeweils äußersten Rotationsdüsen einer Düsenreihe vom gemeinsamen Mittelpunkt 60 bis 95% des Scheibenradius.

Die Rotationsdüsen liegen zweckmäßig jeweils in zum Plattenboden der Führungsplatte 1 senkrechten Ebenen, wobei Abweichungen um etwa ±5° aus der genau senkrechten Orientierung noch toleriert werden können. Diese Ebenen schneiden die Linien, entlang derer die Düsen ausgehend von dem gemeinsamen Mittelpunkt angeordnet sind, unter einem rechten Winkel, wobei ebenfalls Abweichungen um ±5° noch zulässig sind. Liegen die Rotationsdüsen also auf Geraden, so sind diese Ebenen im wesentlichen parallel ausgerichtet. Bilden die Reihen der Rotationsdüsen gekrümmte Linien, beispielsweise Kreislinien, so schneiden sich die Ebenen bei idealer Ausrichtung in einer Geraden, die senkrecht durch den Krümmungsmittelpunkt verläuft. In der Praxis sind jedoch die genannten Abweichungen von der idealen Ausrichtung noch zulässig. Es wurde weiterhin gefunden, daß die Scheiben bei der Rotation gegenüber Auslenkungen besonders unempfindlich sind, wenn der jeweilige Krümmungsmittelpunkt außerhalb des Scheibenumfanges liegt.

Die Rotationsdüsen sind in Rotationsrichtung geneigt; der Neigungswinkel gegenüber dem Plattenboden beträgt, jeweils in Rotationsrichtung gesehen, 10 bis 80°, vorzugsweise 30 bis 60° und günstig etwa 45°.

Um zu verhindern, daß insbesondere bei naßchemischen Behandlungen der rotierenden Scheiben aufgrund der Zentrifugalkräfte in der Scheibenmitte unterversorgte Bereiche entstehen, kann eine zentrale Zuleitung 9 vorgesehen werden, mit deren Hilfe das jeweils eingesetzte, insbesondere wässrige Medium zusätzlich auch zentral von unten und/oder oben auf die Scheibe aufgebracht werden kann. In diesem Zusammenhang wurde überraschend durch Tests mit gefärbten Lösungen gefunden, daß bei in der erfindungsgemäßen Vorrichtung rotierenden Scheiben keine Verschleppung von auf die Scheibenoberseite aufgebrachtem Medium auf die Scheibenunterseite und umgekehrt zu beobachten ist, was beispielsweise bei der Reinigung von Halbleiterscheiben von Bedeutung ist.

Ist bei der Vorrichtung gemäß der bevorzugten Ausführungsform ein Rotationsbereich vorgesehen, so verlaufen zweckmäßig die Fronten zwischen den Vorschub- und den Bremsdüsen nicht senkrecht zur Transportrichtung, sondern schräg, wobei jeweils diejenigen Düsen gegenüber dem senkrechten Frontverlauf vorgeschoben sind, bei denen die Austrittsrichtung des Fluides mit der vorgesehenen Rotationsrichtung übereinstimmt. Bei dieser Anordnung, die auch bei der in der Figur dargestellten Anordnung im Randbereich verwirklicht ist, entsteht bereits beim Bremsvorgang ein auf die Scheiben wirkender Drehimpuls, der einerseits die Rotation erleichtert und andererseits auch die rasche Positionierung der Scheibe in der Drehposition begünstigt. Der Rotationsbereich 8 braucht dabei aber nicht unbedingt auch mit Vorschub- bzw. Bremsdüsen bestückt zu sein, da insbesondere beim bevorzugten Einsatz von wässrigen Medien die von den umgebenden Düsen freigegebene Flüssigkeitsmenge erfahrungsgemäß die Scheibe trägt, auch ohne daß die Rotationsdüsen bereits in Betrieb sind. Allerdings sind auch sich überschneidende Bereiche nicht ausgeschlossen, bei denen die Front zwischen Vorschub- und Bremsdüsen durch den Rotationsbereich verläuft, insbesondere wenn Scheiben mit großen Durchmessern von beispielsweise etwa 20 cm und darüber transportiert, abgebremst und in Drehung versetzt werden sollen.

In dem genannten Fall sich überschneidender Bereiche oder bei Anordnungen ohne Rotationsbereich, bei denen die Scheibe lediglich abgebremst wird, verlaufen vorteilhaft die Fronten der Vorschub- und der Bremsdüsen genau oder im wesentlichen parallel zueinander. Dabei kommt sowohl ein gerader, beispielsweise rechtwinklig oder schräg zur Längsachse der Führungsplatte gerichteter, als auch ein gekrümmter Frontverlauf in Frage, beispielsweise wenn eine Art Auffangstellung mit kreisförmig oder parabelförmig zurückgenommenem Mittelabschnitt des Bremsdüsensystems vorgesehen ist.

Der Längsschnitt entlang der Linie A-A zeigt schematisch eine Anordnung, die gemäß der bevorzugten Ausführungsform mit einer Abdeckung 10 versehen ist. Sowohl in den Plattenboden 3 als auch in die Abdeckung 10 sind die voneinander unabhängigen Versorgungskanalsysteme 4, 6 und 7 eingebracht, welche die in Transportrichtung, die von links nach rechts verläuft, geneigten oberen und unteren Vorschubdüsen 11, die gegen die Transportrichtung geneigten oberen und unteren Bremsdüsen 12 und die in Rotationrichtung geneigten oberen und unteren Rotationsdüsen 13 mit Fluid, insbesondere wässrigem Medium versorgen. Bewährt hat sich dabei eine annähernd spiegelbildliche Anordnung der Düsensysteme, insbesondere der Bremsdüsen, in der Abdeckung und im Plattenboden, obwohl auch andere, beispielsweise reißverschlußartig alternierende Anordnungen nicht ausgeschlossen sind. Grundsätzlich können auch die Kanäle in der Abdeckung und im Plattenboden gegeneinander versetzt sein, oder die Düsen unter verschiedenen Neigungswinkeln angeordnet sein.

Für eine gleichmäßige Einwirkung der jeweils eingesetzten Medien auf die Vorder- und Rückseite der Scheibe bei der Rotation hat es sich als günstig erwiesen, im Rotationsbereich eine Verengung 14 vorzusehen, in der sich die Abdeckung 10 an den Plattenboden 3 annähert und somit die Durchflußhöhe verringert. Vorteilhaft wird die Verengung 14 über eine ein- und ausgangsseitige Abschrägung der Abdeckung erzeugt, bis der vorgesehene Abstand zum Plattenboden erreicht ist, der typisch etwa 3 bis 5 mm entspricht. Die Abweichung von der Horizontalen wird im Bereich der Abschrägung zweckmäßig gering gehalten; in den meisten Fällen haben sich Werte von bis zu etwa 10° bewährt, wobei gegebenenfalls in den Übergangsbereichen von und zu der Horizontalen die Kanten verrundet sein können.

Die verschiedenen Düsensysteme brauchen nicht andauernd und kontinuierlich in Betrieb zu sein. Schon um den Verbrauch an Fluid gering zu halten, werden vorzugsweise Steuerungssysteme vorgesehen, bei denen vorteilhaft durch die durchlaufende Scheibe ausgelöste Steuerimpulse jeweils das erforderliche Düsensystem in Betrieb setzen. Tritt beispielsweise eine Scheibe, insbesondere Halbleiterscheibe in die Vorrichtung ein, so werden günstig zunächst nur die über das Versorgungskanalsystem 4 beschickten Vorschubdüsen 11 in Funktion gesetzt, um die Scheibe ins Innere vorrücken zu lassen. Bei Erreichen einer bestimmten Position, die beispielsweise mittels eine optischen Sensors überwacht sein kann, werden die Bremsdüsen 12 über das Versorgungskanalsystem 6 ebenfalls in Betrieb genommen, so daß sich ein dem durch die Vorschubdüsen gebildeten Fluidstrom entgegengesetzter Strom ausbildet. Die Vorrückbewegung der Scheibe verlangsamt sich beim Eintritt in den Gegenstrombereich immer weiter, bis die Scheibe schließlich zum Stehen kommt und die Rotationsposition erreicht hat. Nun werden, vorteilhaft ebenfalls sensorgesteuert, die Rotationsdüsen 13 eingeschaltet, und die Scheibe beginnt sich mit steigender Geschwindigkeit zu drehen. Beispielsweise konnten mit analog der Fig. 1 gestalteten Vorrichtungen bei Siliciumscheiben mit ca. 20 cm Durchmesser Drehgeschwindigkeiten von etwa 60 UPM erzielt werden. Als Fluid kam dabei Wasser zum Einsatz, der Druck betrug etwa 450 kPa.

Nach Ablauf der vorgesehenen Rotationszeit wird die Fluidzufuhr durch die Rotationsdüsen und die Bremsdüsen unterbrochen, während die noch nicht in Betrieb befindlichen Vorschubdüsen in der Führungsplatte in Betrieb gesetzt werden, so daß alle Vorschubdüsen, also die über die Versorgungskanalsysteme 4 und 5 beschickten, in Funktion sind. Die Scheibe setzt sich dadurch erneut in Transportrichtung in Bewegung und verläßt schließlich die Führungsplatte. Zweckmäßig über eine Sensorsteuerung kann dann die Fluidzufuhr über das Versorgungskanalsystem 5 wieder beendet werden, während eingangsseitig eine weitere Scheibe eingeführt und transportiert werden kann. Grundsätzlich kann die Steuerung auch von Hand vorgenommen werden, beispielsweise im Versuchsbetrieb oder bei der Optimierung der Betriebsparameter.

Als vorteilhaft hat es sich auch erwiesen, wenn an der Vorrichtung ein- und/oder ausgangsseitig mindestens ein von den Scheiben zu durchlaufender Flüssigkeitsrückhalter vorgesehen ist, beispielsweise um von der vorherigen Behandlungsstufe etwaige noch anhaftende Reste von Flüssigkeiten, Reagentien oder Partikeln entfernen zu können, oder aber um die Gefahr einer Verschleppung von Fluidresten aus der Vorrichtung in die nachfolgende Behandlungsstufe gering zu halten. Die Rückhaltewirkung kann beispielsweise mit Hilfe von Flüssigkeitsvorhängen oder -strahlen erzielt werden, die die entsprechende Breite aufweisen, um auf die gesamte durchtretende Scheibenoberfläche einwirken zu können. Dabei kommt der Rückhalteeffekt durch die Relativgeschwindigkeit zwischen durchtretender Scheibe und Flüssigkeitsvorhang bzw. -strahl zustande. Gegebenenfalls können auch mehrere hintereinandergeschaltete Flüssigkeitsrückhalter vorgesehen sein. Bevorzugt werden derartige Flüssigkeitsrückhalter mit dem jeweils in der Vorrichtung eingesetzten Medium beschickt.

Eine besonders geringe Verschleppung von Fluid, insbesondere wässrigen Lösungen mit der transportierten Scheibe aus der Vorrichtung nach außen kann erzielt werden, wenn mindestens einem, vorteilhaft dem letzten, Flüssigkeitsrückhalter eine Trockenzone nachgeschaltet ist, in der ein Gasstrom, beispielsweise von, gegebenenfalls auch erwärmter, Luft oder Stickstoff, über die Oberfläche der austretenden Scheibe geleitet wird. Es wurde gefunden, daß die durch die erfindungsgemäße Vorrichtung transportierten Scheiben nach Durchlaufen einer derartigen Kombination aus Rückhalter und einer Trockenzone, bevorzugt mit erwärmter Luft, nur noch überraschend geringe Spuren von Partikeln und denjenigen wässrigen Medien aufweisen, die vorher als Fluid zum Transport, Abbremsen und gegebenenfalls Rotieren eingesetzt wurden. Derartige Kombinationen aus Führungsplatte mit Rückhalter und Trockenzone lassen sich ihrerseits wieder untereinander kombinieren bzw. hintereinanderschalten, so daß sich letztlich ganze Behandlungsstraßen aufbauen lassen, in denen die Scheiben nacheinander mit wechselnden Fluiden beschickte Vorrichtungen durchlaufen und somit beispielsweise hintereinander geätzt, gespült, gereinigt, oder anderen naßchemischen Behandlungsschritten unterworfen werden können.

In der Figur 2 ist ein möglicher Ausschnitt aus einer derartigen Behandlungsstraße dargestellt. Sie zeigt zunächst eine Startposition 15, in der die Scheiben beispielsweise in einer Prozeßhorde bereitgestellt und z.B. mittels Wasser- oder Luftdüsen ausgehordet werden können. Die Scheiben treten dann in die erste Behandlungsstation 16 ein, die sich beispielsweise in einer nur schematisch angedeuteten Wanne 17 befindet, die zum Auffangen der in dieser Station austretenden Flüssigkeitsmenge dient. Die Scheibe wird zunächst mit Hilfe der Einschleusdüsen 18 auf Geschwindigkeit gebracht und tritt dann in die Führungsplatte 1 der eigentlichen Vorrichtung ein, in der sie in der bereits erläuterten Weise transportiert, abgebremst, rotiert, und weiterbewegt wird. Nach dem Verlassen der Führungsplatte 1 erhält die Scheibe von den Ausschleusdüsen 19 noch einen weiteren Bewegungsimpuls und tritt dann durch den Flüssigkeitsrückhalter 20 und durch die beispielsweise als Trockenzone gestaltete Trennzone 21 in die zweite Behandlungsstation 22 ein, die im Grunde analog der ersten aufgebaut ist, und mit dem gleichen, aber auch mit einem anderen Fluid beschickt sein kann. Entsprechend diesem Prinzip können sich noch beliebig viele weitere Behandlungsstationen anschließen. In den verschiedenen Stationen können mit besonderem Vorteil verschiedene wässrige Medien als Fluide eingesetzt werden, wie etwa reines Wasser, saure Lösungen, Tenside enthaltende Lösungen oder oxidierende Lösungen. In den Trennzonen 21 können auch, neben oder anstelle einer Trocknung der Scheibe, Behandlungsschritte wie z.B. Wasch-, Spül- oder Neutralisationsvorgänge vorgenommen werden.

Derartige Vorrichtungen eignen sich also in besonderem Maße für Verfahren zur naßchemischen Oberflächenbehandlung von scheibenförmigen Werkstücken, insbesondere Halbleiterscheiben, bei denen eine oder mehrere flüssige Phasen zur Einwirkung auf die Scheibenoberfläche gebracht werden und die Scheiben mindestens einem Transportvorgang mittels fluider Medien unterworfen werden. Bei solchen Verfahren kann nur bei einem oder bei getrennten Behandlungsschritten jeweils eine erfindungsgemäße Vorrichtung eingesetzt werden, wobei dann als fluides Medium diejenige Flüssigkeit eingesetzt wird, die bei der jeweiligen Prozeßstufe auch zur Einwirkung auf die Scheibenoberfläche gelangen soll. Gemäß der bevorzugten Ausführungsform kommen bei derartigen Verfahren jedoch in der weiter oben beschriebenen Art mehrere, mindestens zwei hintereinandergeschaltete Vorrichtungen zum Einsatz. Dabei werden von Station zu Station unterschiedliche Flüssigkeiten als fluides Medium eingesetzt, wobei beim Übergang von Station zu Station die Scheiben eine Spül- und Trockenzone, günstig in Form eines Waschvorhanges und eines Trockengasstromes durchlaufen und so weitgehend von der in der vorherigen Station eingesetzten Flüssigkeit befreit werden. Als Fluide werden dabei bevorzugt wässrige Medien eingesetzt, und zwar können beispielsweise alle derzeit für die naßchemische Oberflächenbehandlung von Halbleiterscheiben im Rahmen des Endreinigungsprozesses bekannten Lösungen verwendet werden.

Der besondere Vorteil liegt dabei darin, daß in einer Behandlungsstation jeweils immer ein wässriges Medium bestimmter Zusammensetzung eingesetzt wird, so daß eine Kontamination durch Chemikalienwechsel ausgeschlossen werden kann, die Gefahr einer Verschleppung in nachfolgende Behandlungsstationen gering und auch die Aufbereitung der wässrigen Medien und eine etwaige Wiederverwendung oder ein Kreislauf innerhalb der Behandlungsstation möglich ist. Des weiteren sind auch für mehrere aufeinanderfolgende Behandlungsschritte mit unterschiedlichen Lösungen keine mechanischen Kontakte oder Transportvorgänge mit mechanisch bewegten Teilen erforderlich, ebensowenig wie für das Abbremsen und Rotieren der Scheibe. Darüber hinaus sind die zum Betrieb erforderlichen hydraulischen Bau- und Antriebselemente verschleißarm und die erforderlichen Druckbereiche leicht zu beherrschen, so daß gegenüber mechanische Transportschritte ausführenden Vorrichtungen und Prozessen neben reineren Produkten, also insbesondere Halbleiterscheiben, auch günstigere Standzeiten erzielt werden.

## Patentansprüche

1. Vorrichtung zum Transportieren und Positionieren von scheibenförmigen Werkstücken, insbesondere Halbleiterscheiben, bei welcher die Werkstücke mit Hilfe fluider Medien über eine mit seitlichen Einfassungen (2) versehene Führungsplatte (1) bewegt werden, wobei die Medien durch im Plattenboden (3) angeordnete, in Transportrichtung geneigte Vorschubdüsen (11) in den Transportraum eingepreßt werden, in welchem mindestens ein Bereich zum Abbremsen und Positionieren der Werkstücke vorgesehen ist, wobei im Abbremsbereich im Plattenboden (3) mit fluidem Medium beaufschlagte Bremsdüsen (12) vorgesehen sind, dadurch gekennzeichnet, daß die Bremsdüsen (12) unter einem gegen die Transportrichtung geneigten Winkel in der Führungsplatte angeordnet sind und zumindest beim Abbremsen und Positionieren eines Werkstückes mit fluidem Medium beaufschlagt werden.

2. Vorrichtung nach Anspruch 1, dadurch gekennzeichnet, daß der Neigungswinkel der Bremsdüsen (12), in Transportrichtung gesehen, 90 bis 170°, vorzugsweise 120 bis 150° beträgt.

3. Vorrichtung nach den Ansprüchen 1 oder 2, dadurch gekennzeichnet, daß im Abbremsbereich zusätzlich ein Rotationsbereich (8) mit in die vorgesehene Drehrichtung geneigten Rotationsdüsen (13) vorgesehen ist, welche bei oder nach dem Abbremsen der Scheibe mit Fluid beaufschlagt werden und die Scheibe in Rotation versetzen.

4. Vorrichtung nach Anspruch 3, dadurch gekennzeichnet, daß die Rotationsdüsen (13) auf mindestens 3, vorzugsweise 4 bis 10 von einem gemeinsamen Mittelpunkt ausgehenden gekrümmten Linien angeordnet sind, deren Krümmungsmittelpunkte in der vorgesehenen Drehrichtung liegen.

5. Vorrichtung nach den Ansprüchen 3 oder 4, dadurch gekennzeichnet, daß die Rotationsdüsen (13) konzentrisch um diesen gemeinsamen Mittelpunkt angeordnet sind.

6. Vorrichtung nach einem oder mehreren der Ansprüche 3 bis 5, dadurch gekennzeichnet, daß der Neigungswinkel der Rotationsdüsen (13) 10 bis 80°, vorzugsweise 30 bis 60° beträgt.

7. Vorrichtung nach einem oder mehreren der Ansprüche 1 bis 6, dadurch gekennzeichnet, daß die Führungsplatte (1) zumindest teilweise mit einer oberen Abdeckung (10) versehen ist.

8. Vorrichtung nach Anspruch 7, dadurch gekennzeichnet, daß auch in der Abdeckung (10) Vorschubdüsen (11), Bremsdüsen (12) und Rotationsdüsen (13) vorgesehen sind.

9. Vorrichtung nach Anspruch 8, dadurch gekennzeichnet, daß die Düsen in der Abdeckung (10) und im Plattenboden (3) annähernd spiegelbildlich angeordnet sind.

10. Vorrichtung nach einem oder mehreren der Ansprüche 1 bis 9, dadurch gekennzeichnet, daß ein- und/oder ausgangsseitig mindestens ein von den Scheiben zu durchlaufender Flüssigkeitsrückhalter (20) vorgesehen ist.

11. Vorrichtung nach Anspruch 10, dadurch gekennzeichnet, daß mindestens einem Flüssigkeitsrückhalter (20) eine als Trockenzone ausgebildete Trennzone (21) nachgeschaltet ist.

12. Verfahren zur naßchemischen Oberflächenbehandlung von scheibenförmigen Werkstücken, insbesondere Halbleiterscheiben, bei dem eine oder mehrere Flüssigkeiten zur Einwirkung auf die Scheibenoberfläche gebracht und die Scheiben mindestens einem Transportvorgang unterworfen werden, dadurch gekennzeichnet, daß die Scheiben mindestens eine Vorrichtung nach einem oder mehreren der Ansprüche 1 bis 11 durchlaufen, wobei die zur Einwirkung zu bringende Flüssigkeit auch für den Transportvorgang in der Vorrichtung eingesetzt wird.

13. Verfahren nach Anspruch 12, dadurch gekennzeichnet, daß die Scheiben mindestens zwei hintereinandergeschaltete Vorrichtungen durchlaufen, wobei von Vorrichtung zu Vorrichtung unterschiedliche Flüssigkeiten eingesetzt werden und beim Übergang in die jeweils nächste Vorrichtung die Scheiben in einer Rückhalte- und Trockenzone zumindest teilweise von der in der vorhergehenden Vorrichtung eingesetzten Flüssigkeit befreit werden.

14. Verfahren nach Anspruch 12 oder 13, dadurch gekennzeichnet, daß als Flüssigkeiten wässrige Medien eingesetzt werden.

## Claims

1. Device for transporting and positioning wafer-type workpieces, in particular semiconductor wafers, in which the workpieces are moved, with the aid of fluid media, across a guideplate (1) provided with lateral walls (2), the media being forced through feed nozzles (11), which are arranged in the plate bottom (3) and inclined in the direction of transportation, into the transportation space in which at least one region is provided for retarding and positioning the workpieces, retardation nozzles (12) supplied with fluid medium being provided in the retardation region in the plate bottom (3) characterised in that the retardation nozzles (12) are arranged in the guideplate at an angle inclined in opposition to the direction of transportation and are supplied with fluid medium at least during the retardation and positioning of a workpiece.

2. Device according to Claim 1, characterised in that the angle of inclination of the retardation nozzles (12), viewed in the direction of transportation, is 90 to 170°, preferably 120 to 150°.

3. Device according to Claims 1 or 2, characterised in that a rotation region (8) having rotation nozzles (13) which are inclined in the planned direction of rotation and which are supplied with fluid during or after the retardation of the wafer and cause the wafer to rotate is additionally provided in the retardation region.

4. Device according to Claim 3, characterised in that the rotation nozzles (13) are arranged on at least 3, preferably 4 to 10 curved lines which originate from a common centre and whose centres of curvature are situated in the planned direction of rotation.

5. Device according to Claims 3 or 4, characterised in that the rotation nozzles (13) are arranged concentrically around said common centre.

6. Device according to one or more of Claims 3 to 5, characterised in that the angle of inclination of the rotation nozzles (13) is 10 to 80°, preferably 30 to 60°.

7. Device according to one or more of Claims 1 to 6, characterised in that the guideplate (1) is at least partially provided with an upper cover (10).

8. Device according to Claim 7, characterised in that feed nozzles (11), retardation nozzles (12) and rotation nozzles (13) are also provided in the cover (10).

9. Device according to Claim 8, characterised in that the nozzles in the cover (10) and in the plate bottom (3) are approximately arranged as mirror images.

10. Device according to one or more of Claims 1 to 9, characterised in that at least one liquid retainer (20) to be passed through by the wafers is provided on the input and/or output side.

11. Device according to Claim 10, characterised in that a separating zone (21) constructed as a drying zone is arranged downstream of at least one liquid retainer (20).

12. Process for the wet-chemical surface treatment of wafer-type workpieces, in particular semiconductor wafers, in which one or more liquids are caused to act on the wafer surface and the wafers are subjected to at least one transportation operation, characterised in that the wafers pass through at least one device according to one or more of Claims 1 to 11, the liquid to be caused to act also being used for the transportation operation in the device.

13. Process according to Claim 12, characterised in that the wafers pass through at least two devices arranged in sequence, different liquids being used from device to device and the wafers being freed at least partially from the liquid used in the preceding device in a retaining and drying zone on passing into the next device in each case.

14. Process according to Claim 12 or 13, characterised in that aqueous media are used as liquids.

## Revendications

1. Dispositif pour transporter et positionner des pièces à usiner en forme de disques, notamment des disques semiconducteurs, dans lequel les pièces à usiner sont déplacées à l'aide de milieux fluidiques par l'intermédiaire d'une plaque de guidage (1) équipée de renfoncements latéraux (2), les milieux étant injectés, au moyen de buses d'avance (11) disposées dans le fond (3) de la plaque et inclinées dans la direction de transport, dans l'espace de transport, dans lequel au moins une zone est prévue pour le freinage et le positionnement des pièces, et dans lequel des buses de freinage (12) chargées par un milieu fluidique sont prévues dans la zone de freinage dans le fond (3) de la plaque, caractérisé en ce que les buses de freinage (12) sont disposées dans la plaque de guidage en faisant un angle par rapport à la direction de transport et sont chargées, au moins lors du freinage et du positionnement d'une pièce, par un milieu fluidique.

2. Dispositif selon la revendication 1, caractérisé en ce que l'angle d'inclinaison des buses de freinage (12) est, lorsqu'on regarde dans la direction de transport, compris entre 90 et 170° et de préférence entre 120 et 150°.

3. Dispositif selon l'une des revendications 1 ou 2, caractérisé en ce que dans la zone de freinage il est prévu en supplément une zone de rotation (8) comportant des buses d'entraînement en rotation (13) qui sont inclinées dans le sens de rotation prévu et qui, lors du freinage ou après le freinage du disque, sont chargées par un fluide et font tourner le disque.

4. Dispositif selon la revendication 3, caractérisé en ce que les buses d'entraînement en rotation (13) sont disposées sur au moins 3 et de préférence entre 4 et 10 lignes courbes, qui partent d'un centre commun et dont les centres de courbure sont situés dans le sens de rotation prévu.

5. Dispositif selon les revendications 3 ou 4, caractérisé en ce que les buses d'entraînement en rotation (13) sont disposées concentriquement autour de ce centre commun.

6. Dispositif selon une ou plusieurs des revendications 3 à 5, caractérisé en ce que l'angle d'inclinaison des buses d'entraînement en rotation (13) est compris entre 10 et 80° et de préférence entre 30 et 60°.

7. Dispositif selon une ou plusieurs des revendications 1 à 6, caractérisé en ce que la plaque de guidage (1) comporte au moins partiellement un capot supérieur (10).

8. Dispositif selon la revendication 7, caractérisé en ce que des buses d'avance (11), des buses de freinage (12) et des buses d'entraînement en rotation (13) sont également prévues dans le capot (10).

9. Dispositif selon la revendication 8, caractérisé en ce que les buses sont disposées approximativement symétriquement dans le capot (10) et dans le fond (3) de la plaque.

10. Dispositif selon une ou plusieurs des revendications 1 à 9, caractérisé en ce qu'il est prévu côté entrée et/ou côté sortie au moins un dispositif (20) de retenue de liquide, qui doit être traversé par les disques.

11. Dispositif selon la revendication 10, caractérisé en ce qu'une zone de séparation (21) agencée sous la forme d'une zone de séchage est installée en aval d'au moins un dispositif (20) de retenue de liquide.

12. Procédé pour réaliser le traitement de surface, par voie chimique humide, de pièces à usiner en forme de disques, notamment de disques semiconducteurs, selon lequel on fait agir un ou plusieurs liquides sur la surface des disques et on soumet les disques au moins à une opération de transport, caractérisé en ce que les disques traversent un dispositif selon une ou plusieurs des revendications 1 à 11, le liquide, qui doit agir, étant également utilisé pour l'opération de transport dans le dispositif.

13. Procédé selon la revendication 12, caractérisé en ce que les disques traversent au moins deux dispositifs montés en série, différents liquides étant utilisés d'un dispositif à l'autre, tandis que, lors du passage au dispositif respectivement suivant, les disques sont libérés au moins partiellement du liquide utilisé dans le dispositif précédent, dans une zone de retenue et de séchage.

14. Procédé selon la revendication 12 ou 13, caractérisé en ce qu'on utilise, comme liquides, des milieux aqueux.
